# EUROPÄISCHE PATENTSCHRIFT

(11) **EP 1 081 819 B1**
(45) Veröffentlichungstag und Bekanntmachung des Hinweises auf die Patenterteilung: **09.04.2008**
(21) Anmeldenummer: 00117827.6
(22) Anmeldetag: 18.08.2000
(51) Int. Cl.: H01S 5/40, G02B 27/10

(54) **Optische Anordnung zur Verwendung bei einer Laserdiodenanordnung sowie Laserdiodenanordnung mit einer solchen optischen Anordnung**
Optical system for use with a diode laser system and diode laser system comprising such an optical system
Sytème optique pour l'utilisation avec un système laser à diode et système laser à diode comprenant un tel sytème optique

(30) Priorität: 21.08.1999 DE 19939750
(43) Veröffentlichungstag der Anmeldung: 07.03.2001
(73) Patentinhaber: Laserline Gesellschaft für Entwicklung und Vertrieb von Diodenlasern GmbH, 56070 Koblenz (DE)
(72) Erfinder: Krause, Volker, 56203 Höhr-Grenzhausen (DE); Ullmann, Christoph, Dr., 53604 Bad Honnef (DE)
(74) Vertreter: Graf, Helmut

(56) Entgegenhaltungen:
- EP-A- 0 984 312
- EP-B- 0 573 375
- US-A- 5 081 637
- US-A- 5 216 687
- US-A- 5 369 661
- US-A- 5 802 092
- US-A- 5 900 981

## Beschreibung

Die Erfindung bezieht sich auf eine Laserdiodenanordnung gemäß Oberbegriff Patentanspruch 1.

Die Strahlung eines Halbleiter-Diodenlasers (hier vereinfacht auch Diodenlaser) ist durch einen stark divergierenden Strahl gekennzeichnet, und zwar im Gegensatz zu anderen konventionellen Laserstrahlquellen, deren Laserstrahl einen Durchmesser von wenigen Millimetern mit einer geringen Stahldivergenz im Bereich von wenigen mrad aufweist, während die Divergenz bei einem Diodenlaser größer als 1000 mrad ist.

Bekannt ist weiterhin auch, daß bei Diodenlasern der Divergenzwinkel in der Ebene senkrecht zur aktiven Schicht, d.h. in der sogenannten "Fast-Axis" größer ist als in der Ebene der aktiven Schicht, d.h. in der sogenannten "Slow-Axis".

Um eine möglichst hohe Laserleistung, beispielsweise von 20- 40 Watt aus einem Halbleiterchip zu erreichen, werden zahlreiche Emitter auf einem sogenannten Barren zusammengefaßt. Üblicherweise werden hierbei 10 - 50 einzelne Emitter oder Emittergruppen in einer Reihe in der Ebene parallel zur aktiven Schicht, d.h. in der Slow-Axis aufeinander folgend angeordnet. Der resultierende Gesamtstrahl eines solchen Barrens hat in der Ebene parallel zur aktiven Schicht einen Öffnungswinkel von ca. 10° und einen Strahldurchmesser von ca. 10 mm. Hieraus ergibt sich eine Strahlqualität in dieser Ebene, die um ein vielfaches geringer ist als die Strahlqualität in der Ebene senkrecht zur aktiven Schicht.

Die Belegungsdichte, die sich aus dem Quotienten der strahlenden Fläche des Laserbarrens zu der Gesamtfläche ergibt, liegt bei derzeit verfügbaren Diodenlaserbarren bei ca. 30 - 50 %; wobei allerdings höhere Belegungsdichten nur einen Impulsbetrieb des Lasers erlauben. Für kontinuierliche Anwendungen sind daher kleinere Belegungsdichten erforderlich.

Um die stark divergente Strahlung eines Diodenlasers für Laseranwendungen, beispielsweise Materialbearbeitung, Medizintechnik, Pumpen von Festkörperlasern usw. nutzbar zu machen, sind im Strahlengang kollimierende und fokussierende optische Anordnungen notwendig. Diese optischen Anordnungen umfassen in der Regel insbesondere einen als Mikrooptik ausgeführten Fast-Axis-Kollimator, der die optische Eigenschaft einer Zylinderlinse aufweist, welche mit ihrer Achse parallel zur Slow-Axis liegt, wobei für sämtliche Emitter eines Diodenlaserbarrens eine eigene, durchgehende Zylinderlinse verwendet wird, und zwar mit kleiner Brennweite in unmittelbarer Nähe der Fassette des Diodenlaserbarrens, d.h. in einem Abstand von nur wenigen 100 µ von den Emittern bzw. von dieser Fassette. Die Korrektur der Divergenz in der Slow-Axis erfolgt dann durch eine nachfolgende Makro-Optik.

Zur Erzielung höherer Leistungen, wie sie z.B. in der Materialbearbeitung, in der Medizintechnik, für das Pumpen von Festkörperlasern usw. notwendig sind, ist es weiterhin auch bekannt, mehrere Reihen von Emittern oder mehrere Diodenlaserbarren in einem Stapel in mehreren Ebenen übereinander vorzusehen, wobei diese Ebenen in Richtung der Fast-Axis gegeneinander versetzt sind und jeder Reihe von Emittern bzw. jedem Diodenlaserbarren jeder Ebene ein eigener Fast-Axis-Kollimator zugeordnet ist.

Bekannt ist speziell auch eine Laserdiodenanordnung (US 5 802 092), bei der der Slow-Axis-Kollimator von einer Vielzahl von in Richtung der Slow-Axis aufeinander folgenden Zylinderlinsenelementen gebildet ist, die mit ihren Achsen jeweils in der Fast-Axis angeordnet sind und von denen jeweils ein Element jeweils einem Emitter einer Reihe von Emittern zugeordnet ist. Die Anordnung ist weiterhin so getroffen, daß die mit den Zylinderlinsenelementen in der Ebene der Slow-Axis kollimierten, parallelen oder im wesentlich parallelen Strahlen der einzelnen Emitter unmittelbar aneinander anschließen, so daß ein Strahlenbündel mit einem hohen Füllfaktor erreicht ist, das dann mit Hilfe einer Fokussierlinse in einem Brennpunkt fokussiert werden kann.

Die nachveröffentlichte europäische Patentanmeldung EP 0984312 A2 betrifft eine optische Anordnung, bei der die Emitter einer Laserdiodenanordnung in wenigstens einer Reihe mit ihrer aktiven Schicht in einer gemeinsamen Ebene (Y-Z-Ebene) angeordnet sind, und zwar in dieser gemeinsamen Ebene in einer ersten Koordinatenachse (Y-Achse) aufeinander folgend. Hierbei wird die wenigstens eine Reihe von Emittern von einem Diodenlaserbarren gebildet. Ferner weist die beschriebene Anordnung zur Kollimation der Laserstrahlung des Diodenlaserbarens einen Fast-Axis-Kollimator auf, der segmentiert ist und aus mehreren in der ersten Koordinatenrichtung (Y-Achse) aufeinander folgende Kollimatorsegmenten besteht.

Aus der US 5,081,637 ist eine Vorrichtung und ein Verfahren zur Erhöhung der Lasersignalstärke eines Lasersystems bekannt, bei der mehrere in Reihe angeordnete Laserlichtquellen beispielsweise Diodenlaser oder ein Diodenlaser-Array in einer ersten Ebene angeordnet sind. In einer der ersten Ebene folgenden zweiten Ebene sind Kollimatorlinsen angeordnet, welche jeweils einem Diodenlaser zugeordnet sind.

Die US 5,369,661 offenbart eine Diodenlaseranordnung mit wenigstens einer Reihe von Laserlicht aussendenden Emitterelementen, die mit ihrer aktiven Schicht in einer gemeinsamen Ebene angeordnet sind und mit wenigstens einer in Strahlrichtung auf die Emitterelemente folgenden Korrekturoptik. Die Korrekturoptik weist in einer Ebene angeordnete "GRIN"-Linsen auf, denen eine asphärische Linse nachgeschaltet ist.

Bekannt ist auch eine Laserdiodenanordnung (US 5,216,687) bestehend aus einem Laserdiodenarray gefolgt von einem GRIN Linsen Feld und einer doppelt zylindrischen Linse. Hierbei stellt die doppelt zylindrische Linse eine als Fast-Axis-Kollimator und als Slow-Axis-Kollimator wirkende Korrekturoptik dar.

Aus der US 5,900,981 ist ein optisches System bestehend aus einem eine Vielzahl von Lichtquellen aufweisenden Diodenlaserbarren bekannt, an den sich im Strahlengang wenigstens eine Korrekturoptik anschließt. Die Korrekturoptik besteht aus einer Vielzahl von in einer Reihe angeordneten Slow-Axis-Kollimatorlinsen sowie einer diesen im Strahlengang folgenden Fast-Axis-Kollimatorlinse.

Bekannt ist ferner aus der US 5,168,401 eine Laserdiodenanordnung mit einer Reihe von Laserlicht aussendenden Emitterelementen die in dieser Reihe mit ihrer aktiven Schicht in einer gemeinsamen Ebene senkrecht zur Fast-Axis angeordnet sind, und zwar in Richtung einer Slow-Axis aufeinander folgend und voneinander beabstandet. Die Laserdiodenanordnung weist wenigstens eine in Strahlrichtung auf die Emitterelemente folgend sich in der Slow-Axis erstreckende Korrekturoptik auf, welche als Fast-Axis-Kollimator und als Slow-Axis-Kollimator wirkt, wobei die Korrekturoptik zumindest in einem als Fast-Axis-Kollimator wirkenden Teil und in einem als Slow-Axis-Kollimator wirkenden Teil jeweils segmentiert ist sowie die eine Reihe von Emitterelementen als Diodenlaserbarren ausgebildet sind. Ferner besteht die Korrekturoptik aus mehreren in der Slow-Axis aufeinander folgenden Korrekturoptik-Segmenten.

Darüber hinaus ist aus der US 5,861,992 eine Laserdiodenanordnung mit einer Reihe von Laserlicht aussehenden Emitterelementen bekannt, die in dieser Reihe mit ihrer aktiven Schicht in einer gemeinsamen Ebene senkrecht zur Fast-Axis angeordnet sind. Ferner ist wenigstens, eine in Strahlrichtung auf die Emitterelemente folgende sich in Richtung der Slow-Axis erstreckende Fokussieroptik vorgesehen, welche als Fast-Axis-Linse und als Slow-Axis-Linse wirkt. Der als Fast-Axis-Linse wirkende Teil sowie der als Slow-Axis-Linse wirkende Teil sind jeweils segmentiert und als mehrere in der Slow-AXis aufeinander folgende Segmente realisiert.

Eine optimale Fokussierung der Strahlung sämtlicher Emitter in einem gemeinsamen Fokus erfordert aber eine optimale Fast-Axis-Kollimation und hiermit eine möglichst parallele Ausrichtung der einzelnen Strahlen der Emitter der jeweiligen Reihe bzw. des jeweiligen Barrens derart, daß die Emitter nach dieser Fast-Axis-Kollimation auf einer möglichst geraden Linie abgebildet werden könnten. Dies ist aber in der Regel in idealer Form nicht realisierbar, und zwar wegen Nicht-Konformitäten, d.h. Abweichungen der Konformität zwischen Diodenlaserbarren und Fast-Axis-Kollimator. Diese Abweichungen können unterschiedlichen Ursprungs sein, beispielsweise bedingt durch Fertigungstolleranzen und/oder Verformung bei der Montage usw.. Derartige Nicht-Konformitäten, die auch bei dem Stand der Technik nicht vermieden sind, führen zu einer Verbreiterung des Fokus in der Fast-Axis und damit zu einer Verschlechterung der Strahlenqualität im Fokus.

Aufgabe der Erfindung ist es, eine optische Anordnung sowie eine Laserdiodenanordnung mit einer solchen optischen Anordnung aufzuzeigen, die diese Nachteile vermeidet. Zur Lösung dieser Aufgabe ist eine Laserdiodenanordnung entsprechend dem Patentanspruch 1 ausgebildet.

Der wesentliche Aspekt der Erfindung ist darin zu sehen, dass die Korrekturoptik zumindest einen im Strahlengang nach dem als Fast-Axis-Kollimator wirkenden Teil angeordneten Slow-Axis-Kollimator aufweist, der den als Slow-Axis-Kollimator wirkenden segmentierten Teil der Korrekturoptik bildet. Der Slow-Axis-Kollimator ist hierbei von einer Vielzahl von Linsenelementen gebildet, die in ihrer optischen Wirkung Zylinderlinsen entsprechen, die mit ihrer Achse in der Fast-Axis orientiert sind, die in Richtung der Slow-Axis aneinander anschließen und von denen jeweils eines einem Emitterelement zugeordnet ist. Durch die Segmentierung der Korrekturoptik in einem Slow-Axis-Kollimator sowie in einem Fast-Axis-Kollimator und der Realisierung des Slow-Axis-Kollimators mittels Zylinderlinsenelementen können durch Nicht-Konformitäten zwischen Diodenlaserbarren bzw. zwischen der Reihe von Emitterelementen und der Korrekturoptik bedingte Verschlechterungen der Strahlqualität im Fokus, insbesondere Verbreiterung des Fokus, wirksam vermieden werden.

Bei Laserdiodenanordnung bestehen in Weiterbildung der Erfindung die verschiedensten Möglichkeiten oder Variationen jeweils für sich oder in beliebiger Kombination, nämlich,
daß die Korrekturoptik die Strahlen der Emitterelemente der wenigstes einen Reihe in Strahlen kollimiert oder umformt, die in der Ebene der Slow-Axis (X-Achse) parallel oder etwa parallel zueinander sind und ohne einander zu überdecken in Richtung der Slow-Axis (X-Achse) aneinander anschließen,
und/oder
daß die Korrekturoptik zumindest einen Fast-Axis-Kollimator für die wenigstens eine Reihe von Emitterelementen aufweist, der den segmentierten Teil der Korrekturoptik bildet und aus mehreren in der Slow-Axis (X-Achse) aufeinander folgenden Kollimatorsegmenten besteht,
und/oder
daß die Kollimatorsegmente des Fast-Axis-Kollimators der wenigstens einen Reihe von Emitterelementen unabhängig justiert und fixiert sind,
und/oder
daß im Strahlengang nach der Korrekturoptik eine Fokussieroptik zur Fokussierung der Laserstrahlen der Emitterelemente in einem gemeinsamen Fokus vorgesehen ist,
und/oder
daß der segmentierte Teil (5) der Korrekturoptik zwei bis fünf Segmente (5') aufweist,
und/oder
daß der Anschlussbereich oder Spalt zwischen zwei aufeinander folgenden Segmenten zwischen zwei Emitterelementen, vorzugsweise in der Mitte oder etwa in der Mitte zwischen zwei Emitterelementen vorgesehen ist,
und/oder
daß der als Slow-Axis-Kollimator wirkende Teil der Korrekturoptik oder der Slow-Axis-Kollimator in einer Ebene angeordnet ist, die durch die Fast-Axis (Y-Achse) und die Slow-Axis (X-Achse) definiert ist und im Strahlengang dort oder in etwa dort vorgesehen ist, wo sich die Randstrahlen der in der Slow-Axis (X-Achse) divergierenden Strahlen mit ihren Randstrahlen schneiden,
und/oder
daß der Slow-Axis-Kollimator von mehreren, vorzugsweise zu einem monolithischen Slow-Axis-Kollimator zusammengefaßten Zylinderlinsen gebildet ist,
und/oder
daß die Kollimatorsegmente des Fast-Axis-Kollmiators Zylinderlinsen sind oder als Zylinderlinsen wirken,
und/oder
daß wenigstens zwei Reihen von Emitterelementen vorgesehen sind, und daß die Reihen mit der Slow-Axis (X-Achse) der Emitterelemente (4) parallel zueinander liegen,
und/oder
daß wenigstens zwei Reihen von Emitterelementen vorgesehen sind und die Emitterelemente (4) der Reihen mit ihren aktiven Schichten in parallelen Ebenen angeordnet sind,
und/oder
daß wenigstens zwei Reihen von Emitterelementen vorgesehen sind, und daß die Reihen zumindest in der Slow-Axis (X-Achse) gegeneinander versetzt sind,
und/oder
daß wenigstens zwei Reihen von Emitterelementen vorgesehen sind, und daß in Strahlengang nach dem Fast-Axis-Kollimator wenigstens ein optisches Kopplungs- und/oder Umlenkelement vorgesehen ist, um die Laserstrahlen der Reihen zu einem gemeinsamen Strahlenbündel zusammenzuführen,
und/oder
daß wenigstens zwei Reihen von Emitterelementen in wenigstens einem Stapel vorgesehen sind, daß die Reihen der Emitterelemente (4) im Stapel in Richtung der Fast-Axis (Y-Achse) gegeneinander versetzt sind, und daß für jede Reihe von Emitterelemente jeweils ein gesonderter, segmentierter Teil der Korrekturoptik oder segmentierter Fast-Axis-Kollimator mit wenigstens zwei Segmenten vorgesehen ist,
und/oder
daß bei mehreren Reihen von Emitterelementen für wenigstens eine Reihe von Emitterelementen ein segmentierter Teil der Korrekturoptik oder ein segmentierter Fast-Axis-Kollimator vorgesehen ist,
und/oder
daß für jede Reihe von Emitterelementen eine gesonderte Korrekturoptik vorgesehen ist,
und/oder
daß für jede Reihe von Emitterelementen ein gesonderter Slow-Axis-Kollimator vorgesehen ist,
und/oder
daß mehrere Reihen von Emitterelementen in wenigstens zwei Stapeln angeordnet sind, wobei die Reihen in jedem Stapel in Richtung der Fast-Axis (Y-Achse) gegeneinander versetzt sind, wobei die wenigstens zwei Stapel (9, 10) in Richtung der Slow-Axis (X-Achse) gegeneinander versetzt sind,
und/oder
daß die Ebenen der Reihen der Emitterelemente der wenigstens zwei Stapel in Richtung der Fast-Axis (Y-Achse) derart versetzt sind, daß die Ebenen der Reihen eines Stapels zwischen Ebenen der Reihen eines anderen Stapels liegen,
und/oder
daß eine für die Strahlen sämtlicher Emitterelemente (4) gemeinsame Fokussieroptik vorgesehen ist,
und/oder
daß der Laserbarren ein Halbleiterlaserchip mit mehreren Emittern ist,
und/oder
daß die Emitterelemente jeweils aus wenigstens einem Laserlicht aussendenden Emitter bestehen,
und/oder
daß die Emitterelemente jeweils aus wenigstens zwei Emittern bestehen, die in einem Abstand voneinander beabstandet sind, welcher kleiner ist als der gegenseitige Abstand der Emitterelemente in jeder Reihe,
und/oder
daß der Abstand zwischen den Emitterelementen sowie die Breite der Emitterelemente in Richtung der Slow-Axis (X-Achse) derart gewählt sind, daß die Belegungsdichte bzw. der Quotient aus der Gesamtlänge der strahlenden Bereiche einer Reihe und deren Gesamtlänge kleiner als 10% ist.

Weiterbildungen der Erfindung sind Gegenstand der Unteransprüche.

Die Erfindung wird im folgenden anhand der Figuren an Ausführungsbeispielen näher erläutert. Es zeigen:
- Fig. 1: in vereinfachter Darstellung und in Draufsicht, eine mit mehreren an einem Diodenlaserbarren (Chip) in der Zeichenebene der Figur 1 (X-Z Ebene) in einer Koordinatenrichtung (X-Achse) aufeinander folgend vorgesehenen Emittern, sowie mit einer optischen Anordnung zur Kollimation und Fokussierung der Strahlen der einzelnen Emitter in einem gemeinsamen Fokus;
- Fig. 2: in vereinfachter Darstellung und in Seitenansicht die Laserdiodenanordnung der Figur 1;
- Fig. 3: eine Darstellung ähnlich Figur 1 bei einer weiteren möglichen Ausführungsform;
- Fig. 4: in vereinfachter Darstellung und in Draufsicht eine weitere mögliche Ausführungsform einer Laserdiodenanordnung gemäß der Erfindung, mit zwei in Richtung der ersten Koordinatenachse (X-Achse) gegeneinander versetzten Stapeln von Diodenlaserbarren, die wiederum jeweils in der Zeichenebene der Figur 4 angeordnet sind, sowie mit einer optischen Anordnung zur Kollimation und zur Fokussierung der Strahlen sämtlicher Emitter in einem gemeinsamen Brennpunkt;
- Fig. 5: in vereinfachter Darstellung eine Seitenansicht der Laserdiodenanordnung der Figur 4;
- Fig. 6: eine Darstellung ähnlich Figur 2 zur Erläuterung des Einflusses von Nichtkonformitäten zwischen einem Diodenlaserbarren und einem Fast-Axis-Kollimators auf die Qualität des Fokus bei der Laserdiodenanordnung der Figuren 1 und 2;
- Fig. 7 und 8: in Draufsicht sowie in Seitenansicht eine weitere mögliche Ausführungsform der erfindungsgemäßen Laserdiodenanordnung;
- Fig. 9 - 12: jeweils in vereinfachter Darstellung und in Draufsicht weitere mögliche Ausführungsformen der erfindungsgemäßen Laserdiodenanordnung;
- Fig. 13 und 14: in Darstellungen entsprechend den Figuren 1 und 2 eine weitere mögliche Ausführung der erfindungsgemäßen Laserdiodenanordnung.

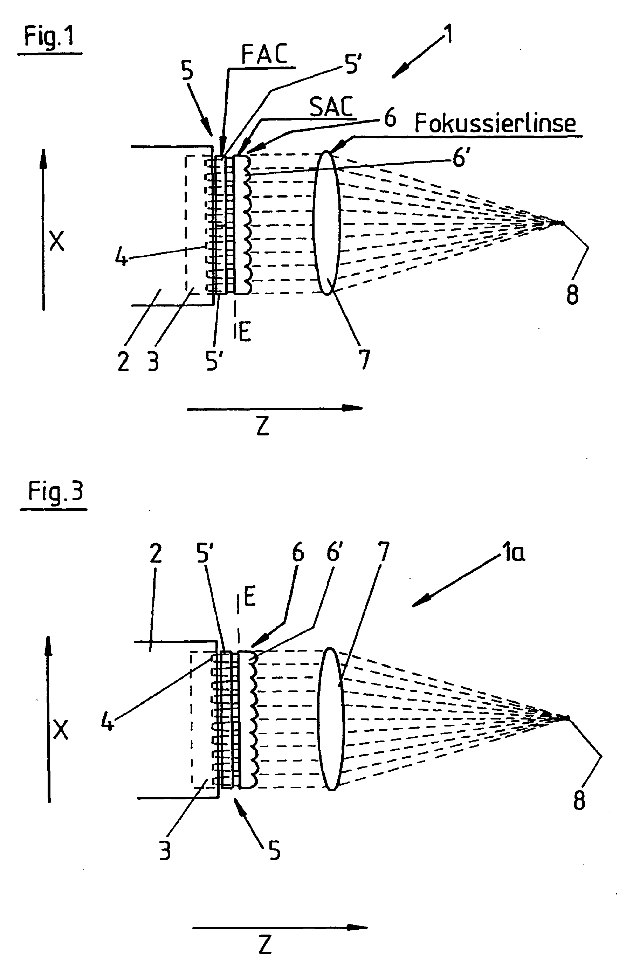

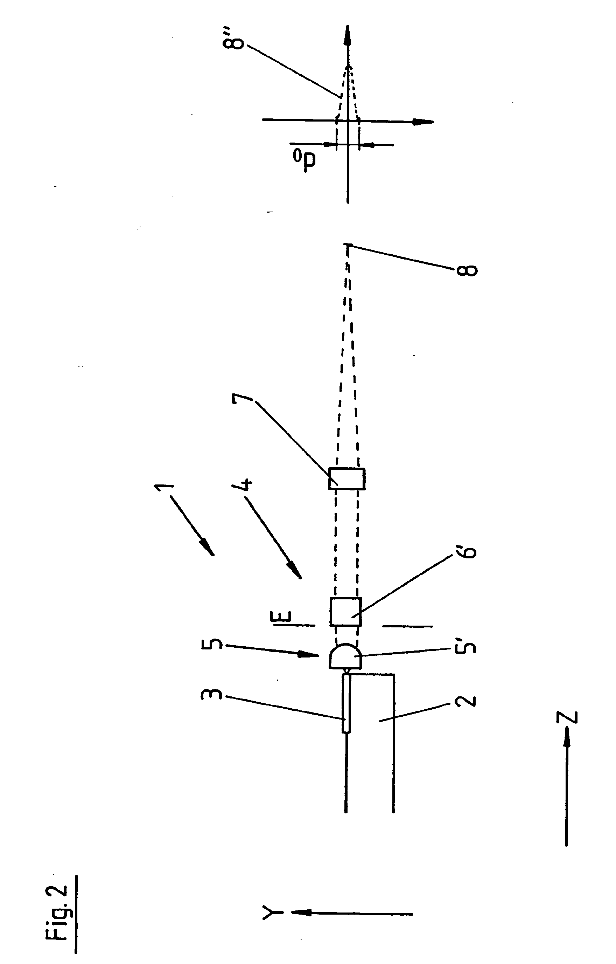

Zum besseren Verständnis und einfacheren Orientierung sind in den Figuren jeweils mit X, Y und Z drei senkrecht zueinander verlaufende Koordinatenachsen angegeben, die nachstehend als X-Achse, Y-Achse und Z-Achse bezeichnet sind und von denen die X-Achse und Z-Achse gemeinsam die Zeichenebene (X-Z-Ebene) der Figuren 1, 3, 4, 7 und 9 - 11 und die Y-Achse und Z-Achse gemeinsam die Zeichenebenen (Y-Z-Ebene) der Figuren 2, 5, 6 und 8 definieren.

In den Figuren 1 und 2 ist eine Laserdiodenanordnung dargestellt, die u.a. aus einem auf einem Kühler 2 (Wärmesenke) angeordneten Diodenlaserbarren 3 besteht, der als Halbleiterchip mit einer Vielzahl von Laserlicht aussendenden Emittern 5 hergestellt ist, die mit ihrer aktiven Schicht im Idealfall in einer gemeinsamen Ebene liegen, nämlich bei der für die Figuren 1 und 2 gewählten Darstellung in der X-Z-Ebene, und in einer in dieser Ebene verlaufenden Achsrichtung aufeinander folgend, d.h. bei der für die Figuren gewählten Darstellung in der Y-Achse aufeinander folgend und voneinander beabstandet am Halbleiterchip bzw. Barren 3 vorgesehen sind. Bei der dargestellten Ausführungsform ist der Laserbarren 3 hinsichtlich der Erstreckung der einzelnen Emitter 4 in Richtung der X-Achse und des Abstandes zwischen diesen Emittern in dieser Achse so ausgebildet, daß sich eine Belegungsdichte kleiner 10% ergibt, d.h. weniger als 10% der Gesamtlänge, die der Barren 3 in Richtung der X-Achse aufweist, ist von den Emittern 4 eingenommen, während der übrige Teil der Länge des Laserbarren 3 nicht strahlend ist.

Die einzelnen Emitter 4 liefern einen Laserstrahl, der sowohl in der Fast-Axis, d.h. in der Y-Achse, als auch in der Slow-Axis, d.h. in der X-Achse eine Divergenz aufweist. Zur Behebung dieser Strahldivergenz sind optische Korrekturelemente vorgesehen, und zwar im Strahlengang auf die Emitter 4 folgend zunächst ein unmittelbar am Laserbarren 3 angeordneter Fast-Axis-Kollimator 5, auf diesen im Strahlrichtung, d.h. in Richtung der Z-Achse folgend ein Slow-Axis-Kollimator 6 und auf diesen folgen eine Fokussiereinrichtung 7, die bei der dargestellten Ausführungsform von einer Fokussierlinse gebildet ist und mit der die Strahlen sämtlicher Emitter 4 in einem gemeinsamen Brennpunkt 8 fokussiert werden.

Wie die Figur 2 zeigt, werden durch den Fast-Axis-Kollimator 5 aus den in der Fast-Axis (Y-Achse) divergierenden Strahlen in der Ebene dieser Fast-Axis parallele Strahlen erzeugt, die allerdings noch in der Slow-Axis, d.h. in der X-Achse eine Divergenz aufweist. Der Fast-Axis-Kollimator 5 besteht bei der dargestellten Ausführungsform aus zwei Segmenten 5', die in Richtung der X-Achse aneinander anschließen, deren Übergang zwischen zwei Emittern an einem nicht aktiven Teil des Laserbarren 3 vorgesehen ist und die jeweils in ihrer Wirkung einer mit ihrer Achse in Richtung der X-Achse sich erstreckenden Zylinderlinse entsprechen. Die beiden Elemente 5' sind individuell bzw. unabhängig voneinander justierbar, und zwar insbesondere durch Höhenverstellung in der Y-Achse sowie durch Kippen um die Z-Achse. Auch in den anderen Achsen können die optischen Elemente 5' individuell justierbar sein. Bei der dargestellten Ausführungsform sind die Elemente 5' tatsächlich Mikro-Zylinderlinsen.

Der Slow-Axis-Kollimator 6 besteht aus mehreren optischen Elementen 6', die in ihrer Wirkung jeweils einer Zylinderlinse entsprechen, die mit ihrer Achse in der Fast-Axis, d.h. bei der gewählten Darstellung in der Y-Achse angeordnet sind. Die Ausbildung ist weiterhin so getroffen, daß für jeden Emitter 4 ein derartiges Element 6' vorgesehen ist. Außerdem ist der Slow-Axis-Kollimator 6 in einer Ebene E senkrecht zum Strahlengang, d.h. senkrecht zur Z-Achse angeordnet, an der sich die Randstrahlen der in der Slow-Axis divergierenden Strahlen benachbarter Emitter 4 schneiden. Außerdem ist das Rastermaß, in welchem die Elemente 6' am Slow-Axis-Kollimator 6 in der Slow-Axis (X-Achse) aufeinander folgend vorgesehen sind gleich dem Rastermaß der Emitter 4 am Laserbarren 3. Die Elemente 6' schließen in Richtung der Slow-Axis unmittelbar aneinander an.

Wie die Figur 1 zeigt, werden mit den Elementen 6' die in der Slow-Axis divergierenden Strahlen der Emitter 4 in Strahlen umgewandelt, die in der Ebene der Slow-Axis (X-Z-Ebene) parallel verlaufen, so daß dann die sowohl in der Fast-Axis, als auch in der Slow-Axis kollimierten Strahlen mittels der Fokussieroptik 7 in dem gemeinsamen Fokus 8 fokussiert werden können.

Die einzelnen Elemente 6' sind bevorzugt zu einem monolithischen Kollimator 6 zusammengefaßt. Durch die relativ geringe Belegungsdichte der Laserbarren 3 ist es in der vorbeschriebenen Weise möglich, für jeden Emitter 4 ein Element 6' vorzusehen. Grundsätzlich besteht auch die Möglichkeit, bei mehreren am Laserbarren 3 gebildeten Emittergruppen, die jeweils wenigstens zwei dicht nebeneinander angeordnete Emitter 4 aufweisen und die dann in einem größeren Abstand voneinander in Richtung der Fast-Axis versetzt vorgesehen sind, für jede dieser Emittergruppen ein gemeinsames optisches Element 6' vorzusehen.

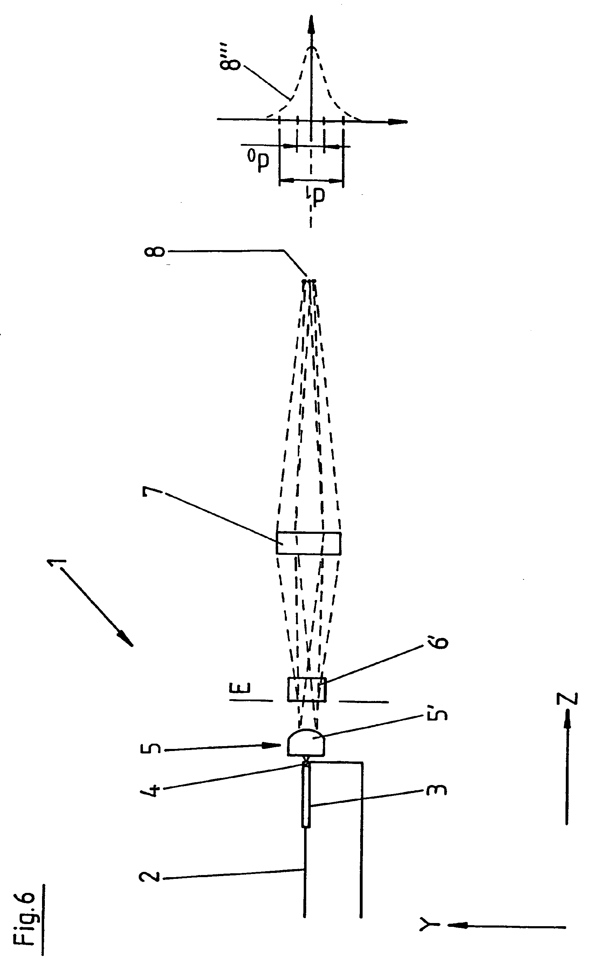

In der Figur 2 ist mit 8" die Verteilung der Leistung im Fokus 8 in der Fast-Axis (Y-Achse) wiedergegeben. Wie oben ausgeführt wurde, kann es durch Abweichungen bzw. Toleranzen zwischen Fast-Axis-Kollimator 5 und Laserbarren 3 zu Fehlern kommen, die dann zu einer Verbreiterung des Fokus 8 in der Fast-Axis führen, wie dies in der Figur 6 mit den unterbrochenen Linien des Strahlungsverlaufs und mit der Verteilung 8''' angedeutet ist. Um diese Fehler zu reduzieren und um den gewünschten, in beiden Achsen gleichen Fokusdurchmesser zu erreichen, ist eine individuelle Justierung der Elemente 5' vorgesehen, mit der dann derartige Toleranzen in der Formgebung der Elemente 5' und des Laserbarren 3 ausgeglichen werden können.

Durch die Segmentierung des Fast-Axis-Kollimators 5 ist es also möglich, für die beiden, den Elementen 5' jeweils zugeordneten Abschnitte des Laserbarren 3 eine optimale Kollimation und Fokussierung zu erreichen. Bezüglich der Qualität des Fokus 8 ist dann nur noch die Formabweichung zwischen dem jeweiligen Element 5' und dem zugeordneten verkürzten Teil des Laserbarrens 3 relevant, wobei diese Formabweichung bzw. Toleranz wegen der kürzeren relevanten Länge des Laserbarrens nur noch einen stark reduzierten Einfluß auf die Qualität des Fokus 8 hat.

Bei der Laserdiodenanordnung 1 ist die Segmentierung so getroffen, daß sämtliche Emitter 4 auf nutzbare Flächen des Fast-Axis-Kollimators 5 strahlen, d.h. die Anschlußbereiche bzw. Spalten zwischen den anschließenden Elementen 5' jeweils zwischen zwei am Laserbarren 3 aufeinander folgenden Emittern 4 liegen.

Die Figur 3 zeigt als zweite Möglichkeit eine Laserdiodenanordnung 1a, die sich von der Anordnung 1 dadurch unterscheidet, daß der Fast-Axis-Kollimator 5 dreifach segmentiert ist, d.h. aus drei Elementen 5' besteht, die jeweils individuell justierbar sind, so daß die jedem Element 5' zugeordnete wirksame Länge des Laserbarren 3 noch kürzer und damit Einflüsse von Toleranzen, die durch das individuelle Justieren der Elemente 5' nicht ausgeglichen werden können, auf die Qualität des Fokus 8 noch geringer sind. Auch bei der Laserdiodenanordnung 1a ist die Segmentierung so getroffen. Daß sämtliche Emitter 4 auf nutzbare Flächen des Fast-Axis-Kollimators Strahlen, d.h. die Anschlußbereiche bzw. Spalten zwischen den anschließenden Elementen 5' wiederum jeweils zwischen zwei am Laserbarren 3 aufeinander folgenden Emittern 4 liegen.

Auch eine andere Segmentierung des Fast-Axis-Kollimators ist selbstverständlich möglich. Bei einem Laserbarren 3 mit z.B. 100 Emittern 4 ist beispielsweise eine zweifache bis fünffache Segmentierung zweckmäßig.

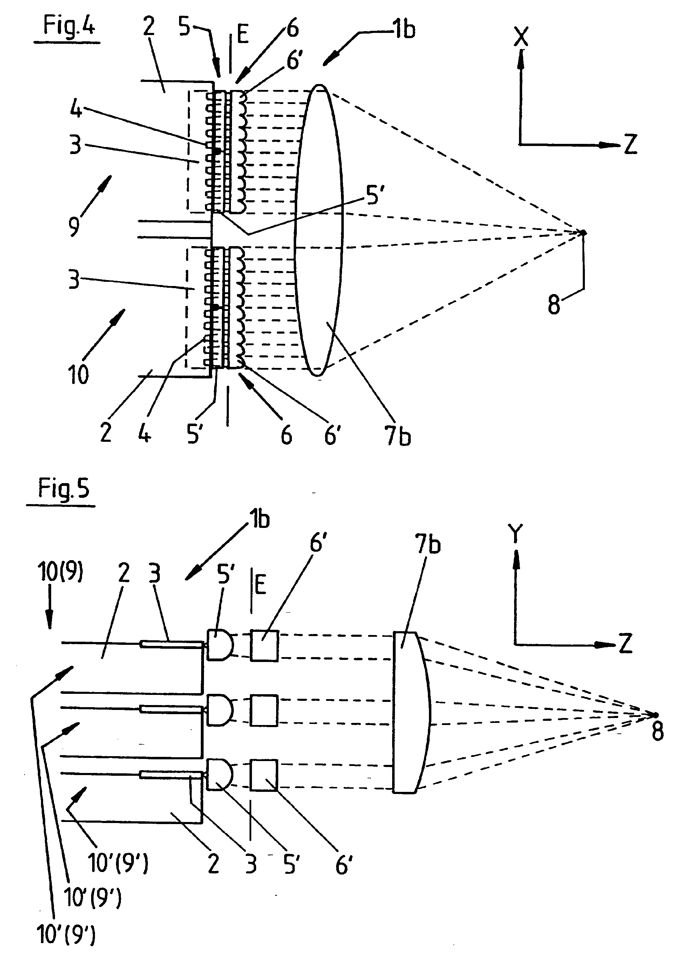

Die Figuren 4 und 5 zeigen als weitere Ausführungsform eine Laserdiodenanordnung 1b, bei der die Laserbarren 3 mit ihren zugehörigen Kühlkörpern 2 in zwei Stapeln 9 und 10 angeordnet. Die Stapel 9 und 10 sind hierbei in Richtung der X-Achse gegeneinander versetzt. In jedem Stapel sind die Laserbarren mit der aktiven Ebene der Emitter 4 in der X-Z-Ebene angeordnet, so daß bei der Darstellung dieser Figuren die Fast-Axis sämtlicher Emitter 4 wiederum die Y-Achse ist und die Emitter 4 an jedem Barren 3 in Richtung der X-Achse aufeinander folgen. In jedem Stapel 9 sind die Laserdiodenbarren 3 weiterhin in Richtung der Y-Achse um einen Abstand y- (Figur 5) gegeneinander versetzt bzw. voneinander beabstandet. Wie die Figuren 4 und 5 weiterhin zeigen, bilden die Stapel 9 und 10 also mehrere Stapellagen 9' bzw. 10', d.h. bei der dargestellten Ausführungsform jeweils drei Stapellagen, wobei jede Stapellage einen Laserbarren 3, einen Fast-Axis-Kollimator 5 und einen Slow-Axis-Kollimator 6 aufweist, die in gleicher Weise angeordnet und ausgebildet sind, wie dies vorstehend für die Laserdiodenanordnung 1 beschrieben wurde. Auch bei der Laserdiodenanordnung 1b sind die Fast-Axis-Kollimatoren 5 jeweils zweifach segmentiert, d.h. sie bestehen jeweils aus zwei individuell justierbaren Elementen 5'.

Die in der Ebene der Fast-Axis und der Slow-Axis kollimierten parallelen Strahlen der einzelnen Emitter 4 werden dann über eine für beide Stapel 9 und 10 gemeinsame Fokussieroptik 7b in den gemeinsamen Fokus 8 fokussiert. Auch bei dieser Ausführung, mit der eine besonders hohe Leistung erreichbar ist, kann durch die individuelle Justierbarkeit der einzelnen Elemente 5' die Strahlenqualität bzw. die Qualität des Fokus 8 wesentlich verbessert werden.

Die Anzahl der Elemente 5' der Fast-Axis-Kollimatoren 5 kann selbstverständlich auch anders gewählt sein. Grundsätzlich besteht auch die Möglichkeit die Anzahl der Elemente 5' in unterschiedlichen Stapellagen 9' bzw. 10' unterschiedlich zu wählen, beispielsweise in einigen Stapellagen die dortigen Fast-Axis-Kollimatoren 5 jeweils zweifach und in einigen Stapellagen dreifach zu segmentieren usw.. Selbstverständlich ist es auch möglich, die Laserbarren 3 nur in einem Stapel oder aber in mehr als zwei Stapeln vorzusehen, wobei es insbesondere auch zweckmäßig erscheint, die Stapelhöhe und Stapelbreite so anzupassen, daß sich in der Slow-Axis und in der Fast-Axis jeweils die gleiche Ausdehnung für das von den Emittern 4 gebildete Strahlungsfeld ergibt. Beispielsweise bei einer Stapelhöhe von 30 mm und einer Stapelbreite von 10 mm würde dann die Laserdiodenanordnung insgesamt drei Stapel aufweisen, die in Richtung der X-Achse nebeneinander angeordnet sind.

Bei der Laserdiodenanordnung 1 b sind, wie vorstehend beschrieben, für die einzelnen Stapellagen 9' und 10' jeweils gesonderte Slow-Axis-Kollimatoren 6 vorgesehen. Hierdurch ist es möglich, diese Kollimatoren 6 in jeder Stapellage individuell in bezug auf den zugehörigen Laserbarren 3 bzw. die dortigen Emitter 4 zu justieren, womit wiederum eine wesentliche Verbesserung der Strahlqualität bzw. des Fokus 8 möglich ist.

Bei der Laserdiodenanordnung 1b ist jeweils eine Stapellage 9' des Stapels 9 in einer gemeinsamen X-Z-Ebene mit einer Stapellage 10' des Stapels 10 angeordnet.

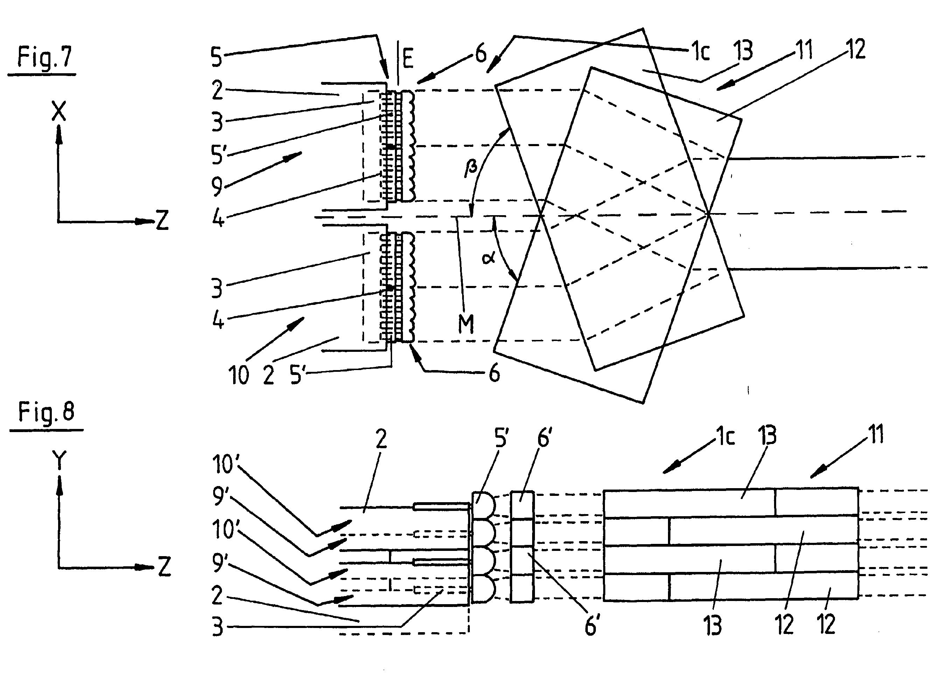

Die Figuren 7 und 8 zeigen als weitere Möglichkeit eine Laserdiodenanordnung 1c, bei der die Ebenen der Stapellagen 9' und 10' und damit die Ebenen der Laserbarren 3 (X-Z-Ebenen) im Stapel 9 gegenüber den entsprechenden Ebenen im Stapel 10 um den halben Abstand y versetzt sind. Durch ein zwischen den Slow-Axis-Kollimatoren 6 und der Fokusier-Optik 7c angeordnetes optisches Element 11 werden die Strahlen der Emitter 4 der Stapellagen 9' und 10' in Richtung der X-Achse kammartig derart übereinandergeschoben, daß im Strahlengang nach dem optischen Element 11 in Richtung der Fast-Axis (Y-Achse) jeweils auf eine Ebene der Strahlen der Stapellage 9' eine Ebene der Strahlen der Stapellage 10' folgt usw.. Das so erzeugte Strahlenbündel wird dann über die gemeinsame Fokussieroptik 7' in den gemeinsamen Fokus fokussiert.

Der einfacheren Darstellung wegen sind in den Figuren 7 und 8 die beiden Stapel 9 und 10 so gezeigt, daß jeder Stapel nur zwei Stapellagen 9' bzw. 10' aufweist, insgesamt also vier Stapellagen und damit auch vier Ebenen vorgesehen sind, in denen Diodenlaserbarren 3 angeordnet sind (Anzahl der Stapel multipliziert mit der Anzahl der Diodenlaserbarren 3 in jedem Stapel).

Die optische Anordnung 11 besteht aus mehreren plattenförmigen Prismen 12 und 13, die in Draufsicht jeweils rechteckförmig ausgebildet sind, und zwar mit gleicher Größe und die mit ihren größeren Oberflächenseiten senkrecht zur Fast-Axis (Y-Achse) orientiert sind und in dieser Achsrichtung übereinandergestapelt aneinander anschließen, und zwar derart, daß jeweils einem Prisma 12 ein Prisma 13 benachbart ist.

Die Prismen 12 sind dem Stapel 9 bzw. jeweils einem Diodenlaserbarren 3 dieses Stapels bzw. einer Stapellage 9' und die Prismen 13 dem Stapel 10 bzw. jeweils einem Diodenlaserbarren 3 bzw. einer Stapellage 10' dieses Stapels zugeordnet. Weiterhin sind die Prismen 12 und 13 mit ihren längeren, in Ebenen senkrecht zur X-Z-Ebene liegenden Umfangsseiten, die auch die Lichteintritts- und -austrittsseiten des jeweiligen Prismas bilden, mit der Mittelebene M, die mittig zwischen den beiden Stapel 9 und 10 und parallel zur Y-Z-Ebene verläuft, einen Winkel α (Prismen 12) bzw. einen Winkel β (Prismen 13) ein. Beide Winkel α und β sind gleich groß und kleiner als 90°, allerdings mit umgekehrtem Vorzeichen in bezug auf die Mittelebene M. Weiterhin sind die Winkel α und β so gewählt, daß unter Berücksichtigung des Brechungsindex beim Eintritt bzw. Austritt der Laserstrahlen in bzw. aus den Prismen 12 und 13 das oben angesprochene Übereinanderschieben der Laserstrahlen in der X-Achse erfolgt. Mit Hilfe einer nicht dargestellten Fokussieroptik können dann die Laserstrahlen sämtlicher Emitter 4 wieder in einem gemeinsamen Fokus fokussiert werden.

Anstelle des optischen Elementes 11 bzw. der Prismen 12 und 13 können auch andere optische Elemente oder Einreichtungen verwendet werden.

Während bei den Laserdiodenanordnungen 1, 1a und 1b im wesentlichen eine Erhöhung des Füllfaktors in dem beispielsweise der Fokussieroptik 7 bzw. 7b zugeführten Gesamtstrahl in der Slow-Axis (X-Achse) erreicht wird, ergibt sich bei der Lasercliodendanordnung 1c durch das kammartige Übereinanderschieben der Laserstrahlen der beiden Stapel 9 und 10 mittels des optischen Elementes 11 auch eine Erhöhung des Füllfaktors in der Fast-Axis (Y-Achse). Verfügen die beiden Stapel 9 und 10 beispielsweise über einen Füllfaktor von 50% in der Fast-Axis (Y-Achse), so ist es mit der Laserdiodenanordnung 1c beispielsweise möglich, die Strahlung der benachbarten Stapel 9 und 10 in ein gemeinsames Strahlungsfeld mit einem optischen Füllfaktor von nahezu 100% zu transferieren. Die Längsseiten der plattenförmigen Prismen 12 und 13 bilden an jedem Prisma parallele Eintritts- und Austrittsflächen, durch die der parallele Versatz bzw. das parallele Verschieben der Laserstrahlen erreicht wird.

Durch die Steigung des Füllfaktors des Strahlenbündels wird bei gleicher Leistung eine Verringerung des Durchmessers des Strahlenbündels erreicht und damit die Strahlqualität, die als Produkt aus Strahldurchmesser und Strahldivergenz definiert ist, bei gleichbleibender Leistung verbessert. Weiterhin wird durch Reduzierung des Durchmessers des Strahlenbündels auch eine nachfolgende Fokussiereinrichtung vereinfacht.

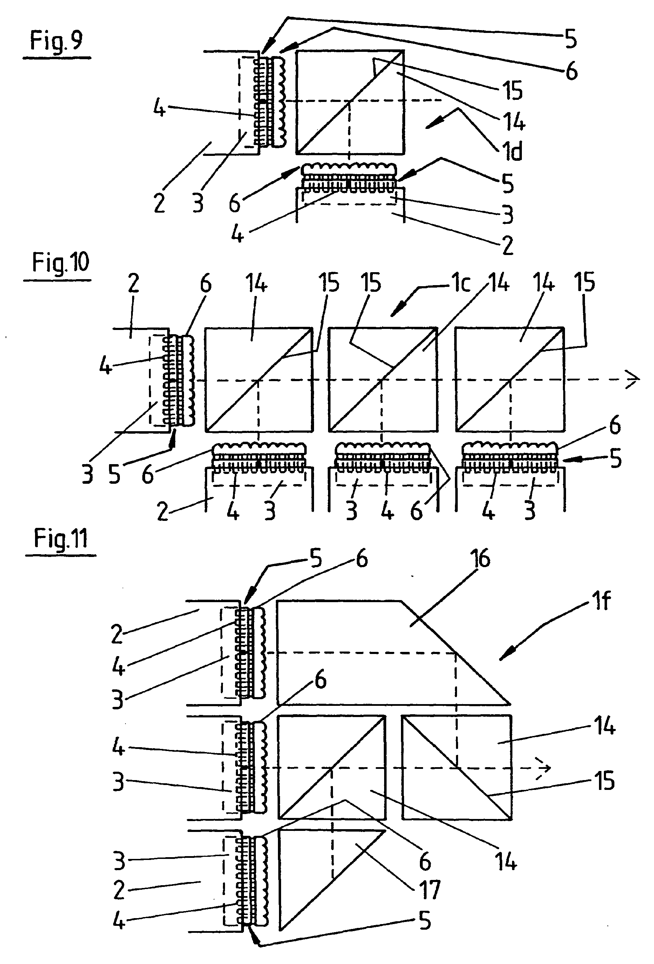

Die Abbildungen 9 - 11 zeigen als weitere mögliche Ausführungen Laserdiodenanordnungen1d, 1e und 1f. Bei der Laserdiodenanordnung1d sind zwei Doidenlaserbarren 3 mit jeweils einem segmentierten Fast-Axis-Kollimator 5 und einem zugehörigen Slow-Axis-Kollimator 6 um 90° versetzt an einem vom einem Prismenwürfel gebildeten Kopplungselement 14 vorgesehen. Durch geeignete dielektrische Filterbeschichtungen auf der unter 45° angeordneten Verbindungsfläche 15 ist die Kombination oder Kopplung von Diodenlaserbarren unterschiedlicher Wellenlänge mittels Kantenfilter bzw. mittels verschiedener Polarisationseinrichtungen mit Polarisationsfiltern möglich.

Bei der Laserdiodenanordnung 1e der Figur 10 sind drei Kopplungselemente 14 dargestellt, und zwar zur Kopplung bzw. Kombination von vier Diodenlaserbarren 3 mit jeweils einem eigenen, segmentierten Fast-Axis-Kollimator 5 und einem eigenen Slow-Axis-Kollimator 6. Insbesondere bei dieser Ausführung mit mehr als zwei Diodenlaserbarren 3 sind auch Abwandlungen denkbar, bei denen nicht nur ausschließlich eine Wellenlängenkopplung oder Polarisationskopplung, sondern auch Kombinationen hiervon verwendet werden.

Die Figur 11 zeigt schließlich als weitere mögliche Ausführungsform eine Laserdiodenanordnung 1f, bei der zusätzlich zu den Kopplungselementen 14 noch Umlenkelemente 16 bzw. 17 verwendet sind, die beispielsweise Umlenkprismen oder Umlenkspiegel sind und die dann eine parallele Anordnung der Laserdiodenbarren 3, der zugehörigen, segmentierten Fast-Axis-Kollimatoren 5 und Slow-Axis-Kollimatoren 6 erlaubt.

Es versteht sich, daß bei den Laserdiodenanordnungen 1d - 1f auch jeweils den Stapeln 9 bzw. 10 entsprechende Stapel mit Stapellagen 9' bzw. 10' verwendet sein können, wobei jede Stapellage wenigstens einen Diodenlaserbarren 3, einen zugehörigen, segmentierten Fast-Axis-Kollimator 5 und einen Slow-Axis-Kollimator 6 aufweist. Bei entsprechender Ausbildung der Koppelelemente 14 und/oder der Umlenkelemente 16 und 17 und bei entsprechend versetzter Anordnung der Stapellagen von Stapel zu Stapel ist es dann auch möglich, die Strahlen zumindest einzelner Diodenlaserbarren 3 unterschiedlicher Stapel zur Erhöhung des Füllfaktors in der Fast-Axis kammartig übereinander zu schieben, wie dies vorstehend für die laserdiodenanorclnung 1c der Figuren 7 und 8 beschrieben wurde und zwar ggf. zusätzlich zu einer Wellenlängen und/oder Polaristationskopplung.

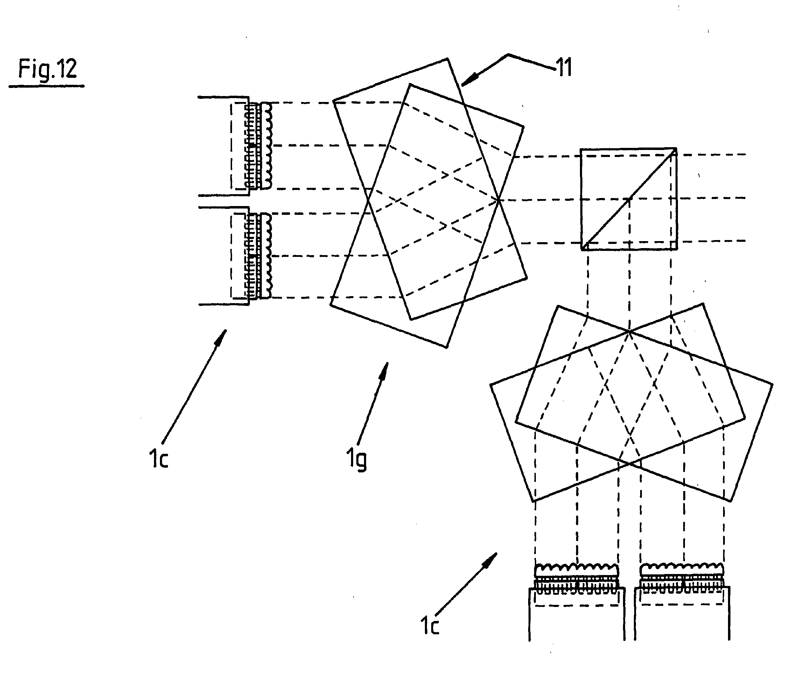

Die Figur 12 zeigt in einer Darstellung ähnlich den Figuren 9 - 11 als weitere mögliche Ausführungsform eine Laserdiodenanordnung 1g, bei der die Laserdiodenanordnung 1c der Figuren 7 und 8 zweifach vorgesehen ist und die Strahlenbündel der beiden optischen Anordnungen 11 über ein optisches Kopplungselement 14 mittels Wellenlängen- und/oder Polarisations-Multiplexing zu einem gemeinsamen Strahlenbündel mit einem besonders hohen Füllfaktor zusammengefaßt werden. Das optische Kopplungselement 14 ist dann beispielsweise wiederum ein solches, wie es vorstehend im Zusammenhang mit den Figuren 9 - 11 beschrieben wurde.

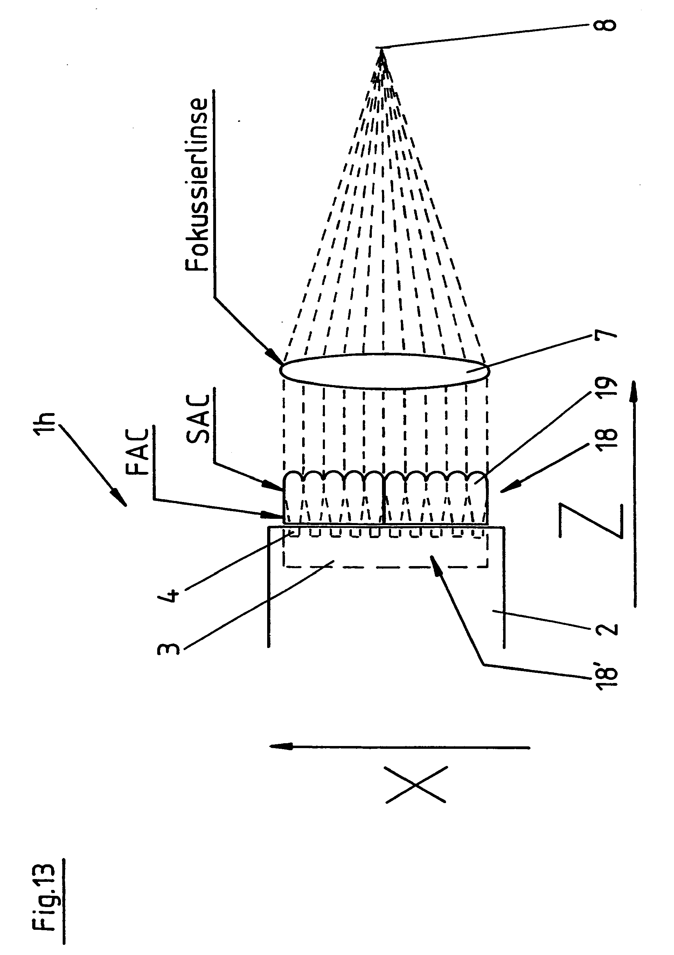

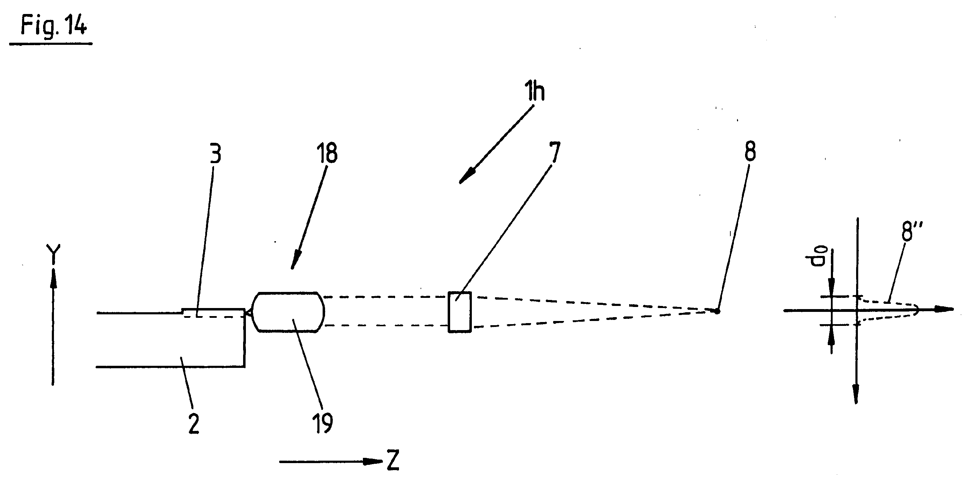

Während bei den Ausführungen der Figuren 1 - 12 davon ausgegangen wurde, daß der Fast-Axis-Kollimator 5 und der Slow-Axis-Kollimator 6 der jeweiligen Korrekturoptik diskrete optische Bauelemente sind, zeigen die Figuren 13 und 14 als weitere mögliche Ausführungsform eine Laserdiodenanordnung 1h, die wiederum auf wenigstens einem Kühler 2 wenigstens einen Diodenlaserbarren 3 mit den Emittern 4 aufweist und bei der im Strahlengang (Z-Achse) auf den Diodenlaserbarren folgend eine Korrekturoptik 18 vorgesehen ist. Diese ist wiederum in Richtung der Slow-Axis (X-Achse) zweifach segmentiert, d.h. sie weist in dieser Achsrichtung zwei aneinander anschließende Segmente 18', von denen zumindest eines individuell im bezug auf den Diodenlaserbarren 3 bzw. die dortigen Emitter justierbar ist.

Jedes Segment 18' besteht aus mehreren Einzellinsen oder Linsenelementen 19, die z.B. monolithische zu den betreffenden Segment 18' zusammengefaßt oder aber als tatsächliche Einzellinsen zu dem betreffenden Segment 18' verbunden sind. Jede Einzellinse 19 hat die Funktion eines Fast-Axis-Kollimators und eines Slow-Axis-Kollimators, und zwar bei der dargestellten Ausführungsform speziell derart, daß die Strahlen der einzelnen Emitter 4 im Strahlengang nach der Korrekturoptik 18 in der Ebene der Slow-Axis parallele oder in etwa parallele Strahlen sind und weiterhin die Strahlen benachbarter Emitter 4 möglichst dicht, allerdings ohne Strahlüberlappung, in Richtung der Slow-Axis (X-Achse) aneinander anschließen. Jedes Linsenelement 19 ist einem Emitter 4 zugeordnet und beispielsweise derart ausgebildet, daß es an seiner Eintrittsfläche eine für die Fast-Axis wirksame Zylinderlinsenfläche und an der Austrittsfläche eine in der Slow-Axis wirkende Zylinderlinsenfläche bildet.

Die Korrektur von Nichtkonformitäten zwischen Diodenlaserbarren 3 und Korrekturoptik 18 erfolgt bei der Laserdiodenanordnung 1h durch entsprechende Justierung der Segmente 18'.

Es versteht sich, daß die Korrekturoptik 18 insbesondere dann, wenn ein Ausgleich von Nichtkonformitäten zwischen dieser Korrekturoptik und dem jeweiligen Diodenlaserbarren 3 nicht erforderlich ist, auch einstückig, d.h. nichtsegmentiert ausgeführt sein kann. Es versteht sich weiterhin, daß die Korrekturoptik 18 selbstverständlich auch bei Laserdiodenanordnungen verwendet werden kann, bei denen zwei oder mehr als zwei Diodenlaserbarren 3, beispielsweise auch in einem oder mehreren Stapeln vorgesehen sind, wobei dann vorzugsweise für jeden Diodenlaserbarren eine eigene Korrekturoptik 18 vorgesehen ist.

Die Erfindung wurde voranstehend an Ausführungsbeispielen beschrieben. Es versteht sich, daß zahlreiche Änderungen sowie Abwandlungen möglich sind, ohne daß damit der der Erfindung zugrundeliegende Erfindungsgedanke verlassen wird. So ist es beispielsweise auch möglich, anstelle von an Laserbarren 3 gebildeten Emittern 4 individuelle Laserdioden mit jeweils nur einem Emitter aufweisen und die dann an einem geeigneten Träger, insbesondere Kühler 2 den Emittern 4 entsprechend in Richtung der Slow-Axis (X-Achse) aufeinander folgend und voneinander beabstandet vorgesehen sind.

### Bezugszeichenliste

- 1, 1a, 1b, 1c, 1d, 1e, 1f, 1g, 1h: Laserdiodenanordnung
- 2: Kühler
- 3: Diodenlaserbarren
- 4: Emitter
- 5: Fast-Axis-Kollimator
- 5': optisches Element
- 6: Slow-Axis-Kollimator
- 6': optisches Element
- 7, 7b: Fokussieroptik
- 8,8b: Fokus
- 9, 10: Stapel
- 9', 10': Stapellage
- 11: optische Anordnung
- 12, 13: Plattenprisma
- 14: optisches Kopplungselement, beispielsweise Prismenwürfel
- 15: die elektrische Filterbeschichtung
- 16, 17: Umlenkelement beispielsweise Umlenkprisma oder Umlenkspiegel
- 18: Korrekturoptik
- 18': Segment der Korrekturoptik
- 19: Linsenelement
- X-Achse:
- Y-Achse:
- Z-Ache:
- X-Y-Ebene:
- Y-Z-Ebene:
- y = Abstand:
- M: Mittelebene
- α, β: Winkel

## Patentansprüche

1. Laserdiodenanordnung mit wenigstens einer Reihe von Laserlicht aussendenden Emitterelementen (4), die von einem Diodenlaserbarren (3) gebildet ist, und die in dieser Reihe mit ihrer aktiven Schicht in einer gemeinsamen Ebene senkrecht zu ihrer Fast-Axis (Y) angeordnet sind, und zwar in Richtung einer Slow-Axis (X) aufeinander folgend und voneinander beabstandet, mit wenigstens einer in Strahlrichtung (Z) auf die Emitterelemente (4) folgenden, sich in der Slow-Axis (X) erstreckenden Korrekturoptik (5, 6), welche als Fast-Axis-Kollimator und als Slow-Axis-Kollimator wirkt, wobei zumindest der als Fast-Axis-Kollimator wirkende Teil (5) der Korrekturoptik (5, 6) **aus mehreren** in der Slow-Axis (X) aufeinander folgenden, **unabhängig voneinander justierbaren** Korrekturoptik-Segmenten (5') **besteht**, **dadurch gekennzeichnet,**
**daß** der als Slow-Axis-Kollimator wirkende Teil (6) in Strahlrichtung (Z) nach dem als Fast-Axis-Kollimator wirkenden Teil (5) angeordnet ist und der als Slow-Axis-Kollimator wirkende Teil (6) von einer Vielzahl von Linsenelementen (6') gebildet ist, die in ihrer optischen Wirkung Zylinderlinsen entsprechen, die mit ihrer Achse in der Fast-Axis (Y) orientiert sind, die in Richtung der Slow-Axis (X) aneinander anschließen und von denen jeweils eines einem Emitterelement (4) zugeordnet ist.

2. Laserdiodenanordnung nach Anspruch 1, **dadurch gekennzeichnet, daß** die Korrekturoptik (5, 6) die Strahlen der Emitterelemente (4) der wenigstens einen Reihe (3) in Strahlen kollimiert oder umformt, die nach dem Austreten aus der Korrekturoptik (5, 6) in der Ebene der Slow-Axis (X) parallel oder etwa parallel zueinander sind und ohne einander zu überdecken in Richtung der Slow-Axis (X) aneinander anschließen.

3. Laserdiodenanordnung nach Anspruch 1 oder 2, **dadurch gekennzeichnet, daß** im Strahlengang nach der Korrekturoptik (5, 6) eine Fokussieroptik (7, 7b, 7c) zur Fokussierung der Laserstrahlen der Emitterelemente (4) in einem gemeinsamen Fokus (8, 8b, 8c) vorgesehen ist,
und/oder
daß die Korrekturoptik zwei bis fünf Kollimatorsegmente (5') aufweist,
und/oder
daß der Anschlussbereich oder Spalt zwischen zwei aufeinander folgenden Kollimatorsegmenten (5') zwischen zwei Emitterelementen (4)vorzugsweise in der Mitte oder etwa in der Mitte zwischen zwei Emitterelementen vorgesehen ist.

4. Laserdiodenanordnung nach einem der vorhergehenden Ansprüche, **dadurch gekennzeichnet,**
**daß** der als Slow-Axis-Kollimator wirkende Teil (6) in einer Ebene (E) angeordnet ist, die durch die Fast-Axis (Y) und die Slow-Axis (X) definiert ist und im Strahlengang dort oder in etwa dort vorgesehen ist, wo sich die Randstrahlen der in der Slow-Axis (X) divergierenden Strahlen mit ihren Randstrahlen schneiden,
und/oder
**daß** der als Slow-Axis-Kollimator wirkende Teil (6) von mehreren, vorzugsweise zu einem monolithischen Slow-Axis-Kollimator (6) zusammengefassten Zylinderlinsen (6') gebildet ist,
und/oder
**daß** die Kollimatorsegmente (5') des als Fast-Axis-Kollimator wirkenden Teil (5) Zylinderlinsen sind oder als Zylinderlinsen wirken,
und/oder
**daß** wenigstens zwei Reihen von Emitterelementen (4) vorgesehen sind, und daß die Reihen mit der Slow-Axis (X) der Emitterelemente (4) parallel zueinander liegen,
und/oder
**daß** wenigstens zwei Reihen von Emitterelementen (4) vorgesehen sind, und daß die Emitterelemente (4) der Reihen mit ihren aktiven Schichten in parallelen Ebenen angeordnet sind,
und/oder
**daß** wenigstens zwei Reihen von Emitterelementen (4) vorgesehen sind, und daß die Reihen zumindest in der Slow-Axis (X) gegeneinander versetzt sind,
und/oder
**daß** wenigstens zwei Reihen von Emitterelementen (4) vorgesehen sind, und daß in Strahlengang nach dem als Fast-Axis-Kollimatorwirkende Teil (5) wenigstens ein optisches Kopplungs- und/oder Umlenkelement (14, 16, 17) vorgesehen ist, um die Laserstrahlen der Reihen zu einem gemeinsamen Strahlenbündel zusammenzuführen,
und/oder
**daß** wenigstens zwei Reihen von Emitterelementen (4) in wenigstens einem Stapel (9, 10) vorgesehen sind, daß die Reihen der Emitterelemente (4) im Stapel (9, 10) in Richtung der Fast-Axis (Y) gegeneinander versetzt sind, und daß für jede Reihe von Emitterelementen (4) jeweils ein gesonderter, segmentierter Teil (5) der Korrekturoptik mit wenigstens zwei Segmenten (5') vorgesehen ist.

5. Laserdiodenanordnung nach einem der vorhergehenden Ansprüche, **dadurch gekennzeichnet, daß** bei mehreren Reihen von Emitterelementen (4) für wenigstens eine Reihe von Emitterelementen (4) ein segmentierter Teil (5) der Korrekturoptik vorgesehen ist.

6. Laserdiodenanordnung nach einem der vorhergehenden Ansprüche, **dadurch gekennzeichnet, daß** für jede Reihe von Emitterelementen (4) eine gesonderte Korrekturoptik (5, 6) vorgesehen ist.

7. Laserdiodenanordnung nach einem der vorhergehenden Ansprüche, **dadurch gekennzeichnet, daß** mehrere Reihen von Emitterelementen (4) in wenigstens zwei Stapeln (9, 10) angeordnet sind, wobei die Reihen in jedem Stapel in Richtung der Fast-Axis (Y) gegeneinander versetzt sind, wobei beispielsweise die wenigstens zwei Stapel (9, 10) in Richtung der Slow-Axis (X) gegeneinander versetzt sind.

8. Laserdiodenanordnung nach einem der vorhergehenden Ansprüche, **dadurch gekennzeichnet, daß** die Ebenen der Reihen der Emitterelemente (4) der wenigstens zwei Stapel in Richtung der Fast-Axis (Y) derart versetzt sind, daß die Ebenen der Reihen eines Stapels (9) zwischen Ebenen der Reihen eines anderen Stapels (10) liegen,wobei beispielsweise eine optische Einrichtung (11) vorgesehen ist, mit der die Strahlen der Emitterelemente (4) in der Slow-Axis (X) derart verschoben werden, daß die Strahlen der Emitterelemente (4) sämtlicher Stapel ein gemeinsames Strahlenbündel bilden.

9. Laserdiodenanordnung nach einem der vorhergehenden Ansprüche, **dadurch gekennzeichnet, daß** der Laserbarren (3) ein Halbleiterlaserchip mit mehreren Emittern (4) ist.

10. Laserdiodenanordnung nach einem der vorhergehenden Ansprüche, **dadurch gekennzeichnet, daß** die Emitterelemente jeweils aus wenigstens einem Laserlicht aussendenden Emitter (4) bestehen,
und/oder
daß die Emitterelemente jeweils aus wenigstens zwei Emittern (4) bestehen, die in einem Abstand voneinander beabstandet sind, welcher kleiner ist als der gegenseitige Abstand der Emitterelemente in jeder Reihe,
und/oder
daß der Abstand zwischen den Emitterelementen sowie die Breite der Emitterelemente in Richtung der Slow-Axis (X) derart gewählt sind, daß die Belegungsdichte bzw. der Quotient aus der Gesamtlänge der strahlenden Bereiche einer Reihe und deren Gesamtlänge kleiner als 10% ist.

## Claims

1. Laser diode arrangement comprising at least one series of emitter elements (4) which emit laser light, which at least one series is formed by a diode laser bar (3) and which emitter elements are arranged in said series with their active layer in a common plane perpendicular to their fast axis (Y), to be precise in a manner succeeding one another and spaced apart from one another in the direction of a slow axis (X), comprising at least one correction optical unit (5, 6) which succeeds the emitter elements (4) in the beam direction (Z), extends in the slow axis (X) and acts as a fast axis collimator and as a slow axis collimator, at least that part (5) of the correction optical unit (5, 6) which acts as a fast axis collimator comprising a plurality of correction optical unit segments (5') which succeed one another in the slow axis (X) and can be adjusted independently of one another,
**characterized**
**in that** the part (6) acting as a slow axis collimator is arranged downstream of the part (5) acting as a fast axis collimator in the beam direction (Z) and the part (6) acting as a slow axis collimator is formed by a multiplicity of lens elements (6') which in terms of their optical effect correspond to cylindrical lenses, which are oriented with their axis in the fast axis (Y), which are adjacent to one another in the direction of the slow axis (X) and each of which is respectively assigned to an emitter element (4).

2. Laser diode arrangement according to Claim 1,
**characterized in that** the correction optical unit (5, 6) collimates or converts the beams of the emitter elements (4) of the at least one series (3) into beams which are parallel or approximately parallel to one another after emerging from the correction optical unit (5, 6) in the plane of the slow axis (5) and are adjacent to one another without overlapping one another in the direction of the slow axis (X).

3. Laser diode arrangement according to Claim 1 or 2,
**characterized in that** there is provided in the beam path downstream of the correction optical unit (5, 6) a focusing optical unit (7, 7b, 7c) for focusing the laser beams of the emitter elements (4) at a common focus (8, 8b, 8c),
and/or
**in that** the correction optical unit has two to five collimator segments (5'),
and/or **in that** the junction region or gap between two collimator segments (5') that succeed one another is provided between two emitter elements (4), preferably in the centre or approximately in the centre between two emitter elements.

4. Laser diode arrangement according to any of the preceding claims, **characterized**
**in that** the part (6) acting as a slow axis collimator is arranged in a plane (E) which is defined by the fast axis (Y) and the slow axis (X) and is provided in the beam path at the location or approximately at the location where the marginal rays of the beams that diverge in the slow axis (X) intersect with their marginal rays,
and/or
**in that** the part (6) acting as a slow axis collimator is formed by a plurality of cylindrical lenses (6'), preferably combined to form a monolithic slow axis collimator (6),
and/or
**in that** the collimator segments (5') of the part (5) acting as fast axis collimator are cylindrical lenses or act as cylindrical lenses,
and/or
**in that** at least two series of emitter elements (4) are provided, and in that the series lie parallel to one another with the slow axis (X) of the emitter elements (4)
and/or
**in that** at least two series of emitter elements (4) are provided, and in that the emitter elements (4) of the series are arranged with their active layers in parallel planes,
and/or
**in that** at least two series of emitter elements (4) are provided, and in that the series are offset relative to one another at least in the slow axis (X),
and/or
**in that** at least two series of emitter elements (4) are provided, and in that in the beam path downstream of the part (5) acting as a fast axis collimator at least one optical coupling and/or deflection element (14, 16, 17) is provided in order to combine the laser beams of the series to form a common beam bundle,
and/or
**in that** at least two series of emitter elements (4) are provided in at least one stack (9, 10), in that the series of the emitter elements (4) in the stack (9, 10) are offset relative to one another in the direction of the fast axis (Y) and in that a separate, segmented part (5) of the correction optical unit with at least two segments (5') is in each case provided for each series of emitter elements (4).

5. Laser diode arrangement according to any of the preceding claims, **characterized in that** in the case of a plurality of series of emitter elements (4), a segmented part (5) of the correction optical unit is provided for at least one series of emitter elements (4).

6. Laser diode arrangement according to one of the preceding claims, **characterized in that** a separate correction optical unit (5, 6) is provided for each series of emitter elements (4).

7. Laser diode arrangement according to any of the preceding claims, **characterized in that** a plurality of series of emitter elements (4) are arranged in at least two stacks (9, 10), the series in each stack being offset relative to one another in the direction of the fast axis (Y), for example the at least two stacks (9, 10) being offset relative to one another in the direction of the slow axis (X).

8. Laser diode arrangement according to any of the preceding claims, **characterized in that** the planes of the series of the emitter elements (4) of the at least two stacks are offset in the direction of the fast axis (Y) in such a way that the planes of the series of one stack (9) lie between planes of the series of another stack (10), for example an optical device (11) being provided which displaces the beams of the emitter elements (4) in the slow axis (X) in such a way that the beams of the emitter elements (4) of all the stacks form a common beam bundle.

9. Laser diode arrangement according to any of the preceding claims, **characterized in that** the laser bar (3) is a semiconductor laser chip with a plurality of emitters (4).

10. Laser diode arrangement according to any of the preceding claims, **characterized in that** the emitter elements in each case comprise at least one emitter (4) which emits laser light,
and/or
**in that** the emitter elements in each case comprise at least two emitters (4) which are spaced apart from one another at a distance which is less than the mutual distance between the emitter elements in each series,
and/or
**in that** the distance between the emitter elements and also the width of the emitter elements in the direction of the slow axis (X) are chosen in such a way that the occupancy density or the quotient of the total length of the radiative regions of a series and the total length thereof is less than 10%.

## Revendications

1. Système de diodes laser comprenant au moins une rangée d'éléments émetteurs (4) émettant de la lumière laser, qui est formée par une barre de diodes laser (3) et dont les éléments émetteurs sont disposés avec leur couche active dans un plan commun perpendiculaire à leur axe rapide (Y) et, en fait, à la suite les uns des autres et à distance les uns des autres dans la direction d'un axe lent (X), et au moins une optique de correction (5, 6) faisant suite aux éléments émetteurs (4) dans la direction des rayons (Z), s'étendant dans l'axe lent (X), laquelle agit comme collimateur de l'axe rapide et comme collimateur de l'axe lent, dans lequel au moins la partie (5) de l'optique de correction agissant comme collimateur de l'axe rapide est constituée de plusieurs segments (5') d'optique de correction se suivant les uns les autres, pouvant être ajustés indépendamment les uns des autres,
**caractérisé**
**en ce que** la partie (6) agissant comme collimateur de l'axe lent est disposée après la partie (5) agissant comme collimateur de l'axe rapide dans la direction des rayons (Z) et la partie (6) agissant comme collimateur de l'axe lent est formée par une pluralité d'éléments de lentille (6') qui correspondent, pour ce qui est de leur effet optique, à des lentilles cylindriques qui sont orientées avec leur axe dans l'axe rapide (Y), qui se suivent les unes les autres dans la direction de l'axe lent (X) et dont une est chaque fois associée à un élément émetteur (4).

2. Système de diodes laser selon la revendication 1, **caractérisé en ce que** l'optique de correction (5, 6) collimate ou déforme les rayons des éléments émetteurs (4) de ladite au moins une rangée (3) en rayons qui, après leur sortie de l'optique de correction (5, 6), sont parallèles dans le plan de l'axe lent (X) ou approximativement parallèles entre eux et sont adjacents les uns aux autres dans la direction de l'axe lent (X) sans se recouvrir les uns les autres.

3. Système de diodes laser selon la revendication 1 ou 2, **caractérisé en ce qu'**il est prévu sur le trajet des rayons, après l'optique de correction (5, 6), une optique de focalisation (7, 7b, 7c) pour focaliser les rayons laser des éléments émetteurs (4) dans un foyer commun (8, 8b, 8c),
et/ou
**en ce que** l'optique de correction présente de deux à cinq segments (5') de collimateur,
et/ou
**en ce que** la région de connexion ou la fente entre deux segments (5') de collimateur se suivant les uns les autres est prévue entre deux éléments émetteurs (4), de préférence, au milieu ou approximativement au milieu entre deux éléments émetteurs.

4. Système de diodes laser selon l'une des revendications précédentes, **caractérisé**
**en ce que** la partie (6) agissant comme collimateur de l'axe lent est disposée dans un plan (E) qui est défini par l'axe rapide (Y) et l'axe lent (X) et est prévue sur le trajet des rayons là ou approximativement là où les rayons marginaux des rayons divergeant dans l'axe lent (X) se coupent avec leurs rayons marginaux,
et/ou
**en ce que** la partie (6) agissant comme collimateur de l'axe lent est formée par plusieurs lentilles cylindriques (6'), de préférence réunies en un collimateur monolithique de l'axe lent (6),
et / ou
**en ce que** les segments (5') de collimateur de la partie (5) agissant comme collimateur de l'axe rapide sont des lentilles cylindriques ou agissent comme des lentilles cylindriques,
et/ou
**en ce qu'**il est prévu au moins deux rangées d'éléments émetteurs (4), et en ce que les rangées avec l'axe lent (X) des éléments émetteurs (4) sont parallèles entre elles,
et/ou
**en ce qu'**il est prévu a moins deux rangées d'éléments émetteurs (4), et en ce que les éléments émetteurs (4) des rangées sont disposés avec leurs couches actives dans des plans parallèles,
et/ou
**en ce qu'**il prévu a moins deux rangées d'éléments émetteurs (4), et en ce que les rangées sont décalées les unes par rapport aux autres au moins dans l'axe lent (X),
et/ou
**en ce qu'**il est prévu au moins deux rangées d'éléments émetteurs (4), et en ce qu'il est prévu sur le trajet des rayons, après la partie (5) agissant comme collimateur de l'axe rapide, au moins un élément optique d'accouplement et/ou de déviation (14, 16, 17) pour réunir les rayons laser des rangées en un faisceau commun de rayons,
et/ou
**en ce qu'**il est prévu deux rangées d'éléments émetteurs (4) dans au moins un empilement (9, 10), en ce que les rangées des éléments émetteurs (4) dans l'empilement (9, 10) sont décalés les uns par rapport aux autres dans la direction de l'axe rapide (Y), et en ce que pour chaque rangée d'éléments émetteurs (4), il est prévu chaque fois une partie segmentée (5) distincte de l'optique de correction avec au moins deux segments (5').

5. Système de diodes laser selon l'une des revendications précédentes, **caractérisé en ce qu'**avec plusieurs rangées d'éléments émetteurs (4), il est prévu une partie segmentée (5) de l'optique de correction pour au moins une rangée d'éléments émetteurs (4).

6. Système de diodes laser selon l'une des revendications précédentes, **caractérisé en ce que** pour chaque rangée d'éléments émetteurs (4), il est prévu une optique de correction (5, 6).distincte.

7. Système de diodes laser selon l'une des revendications précédentes, **caractérisé en ce que** plusieurs rangées d'éléments émetteurs (4) sont disposées dans au moins deux empilements (9, 10), les rangées dans chaque empilement étant décalées les unes par rapport aux autres dans la direction de l'axe rapide (Y), lesdits aux moins deux empilements (9, 10) étant décalés l'un par rapport à l'autre dans la direction de l'axe lent (X).

8. Système de diodes laser selon l'une des revendications précédentes, **caractérisé en ce que** les plans des rangées des éléments émetteurs (4) desdits au moins deux empilements sont décalées dans la direction de l'axe rapide (Y) de telle manière que les plans des rangées d'un empilement (9) soient situés entre des plans des rangées d'un autre empilement (10), un dispositif optique étant par exemple prévu, dispositif avec lequel les rayons des éléments émetteurs (4) sont déplacés dans l'axe lent (X) de telle manière que les rayons des éléments émetteurs (4) de tous les empilements forment un faisceau commun de rayons.

9. Système de diodes laser selon l'une des revendications précédentes, **caractérisé en ce que** la barre laser (3) est une puce semi-conductrice avec plusieurs émetteurs (4).

10. Système de diodes laser selon l'une des revendications précédentes, **caractérisé en ce que** les éléments émetteurs sont constitués respectivement d'au moins un émetteur (4) émettant de la lumière laser,
et/ou
**en ce que** les éléments émetteurs sont constitués respectivement d'au moins deux émetteurs (4) qui sont espacés les uns des autres d'une distance qui est plus petite que la distance réciproque des éléments émetteurs dans chaque rangée,
et/ou
**en ce que** la distance entre les éléments émetteurs ainsi que la largeur des éléments émetteurs dans la direction de l'axe lent (X) sont choisies de telle manière que la densité d'occupation ou le quotient de la longueur totale des zones rayonnantes d'une rangée et de leur longueur totale soit inférieure à 10 %.
